(19) Europäisches Patentamt
European Patent Office
Office européen des brevets

(11) **EP 2 960 657 A1**

(12) **DEMANDE DE BREVET EUROPEEN**

(43) Date de publication:
**30.12.2015 Bulletin 2015/53**

(51) Int Cl.:
***G01R 1/067*** *(2006.01)*     ***G01R 31/28*** *(2006.01)*
***G01R 27/20*** *(2006.01)*

(21) Numéro de dépôt: **15173463.9**

(22) Date de dépôt: **23.06.2015**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**
Etats de validation désignés:
**MA**

(30) Priorité: **24.06.2014 FR 1455857**

(71) Demandeur: **Commissariat à l'Énergie Atomique et aux Énergies Alternatives**
**75015 Paris (FR)**

(72) Inventeur: **BEN JAMAA, Haykel**
**38000 GRENOBLE (FR)**

(74) Mandataire: **Brevalex**
**95, rue d'Amsterdam**
**75378 Paris Cedex 8 (FR)**

(54) **PROCEDE DE CARACTERISATION D'UN DISPOSITIF DE CONNEXION ELECTRIQUE DESTINE A ETRE CONTACTE A UN DISPOSITIF ELECTRONIQUE**

(57)     Procédé de caractérisation d'un dispositif de connexion électrique (10) destiné à être hybridé à un dispositif électronique (22) et comportant des éléments de connexion électrique (14) chacun destiné à être en contact électrique avec au moins un d'une pluralité de plots de contact (20) du dispositif électronique qui sont reliés électriquement entre eux, comprenant au moins une étape (104) de sélection d'un élément de connexion électrique de référence parmi lesdits éléments de connexion électrique, puis, pour le ou chacun des éléments de connexion électrique autres que l'élément de connexion électrique de référence, la mise en oeuvre des étapes suivantes :
- application (108) d'une tension électrique de référence entre l'élément de connexion électrique de référence et ledit élément de connexion électrique ;
- mesure (108) d'un courant électrique circulant à travers l'élément de connexion électrique de référence et ledit élément de connexion électrique, ou d'une résistance électrique entre l'élément de connexion électrique de référence et ledit élément de connexion électrique, en faisant varier la position dudit élément de connexion électrique par rapport à l'un des plots de contact disposé en regard dudit élément de connexion électrique ;
- détermination (114, 124, 126, 130, 132, 136) de l'existence d'au moins une valeur d'un paramètre lié à la position dudit élément de connexion électrique pour laquelle un contact électrique est correctement établi entre ledit élément de connexion électrique et ledit plot de contact.

FIG. 1

EP 2 960 657 A1

Printed by Jouve, 75001 PARIS (FR)

**Description**

**DOMAINE TECHNIQUE ET ART ANTÉRIEUR**

L'invention concerne un procédé de caractérisation d'un dispositif de connexion électrique destiné à être hybridé à un dispositif, ou circuit, électronique. L'invention s'applique notamment à la caractérisation, ou calibrage, d'une carte à pointes destinée à être utilisée pour tester un dispositif électronique comportant des plots de contact reliés électriquement entre eux.

Les circuits électroniques dits « 3D » et les circuits photoniques comportent généralement des plots de contact réalisés avec un faible pas, ou période, généralement inférieur ou égal à environ 100 $\mu$m. Ces plots de contact sont de petites tailles et fragiles mécaniquement. Ils correspondent par exemple à des piliers de cuivre réalisés sur du silicium en couche mince (épaisseur inférieure à environ 100 $\mu$m) et dans des niveaux d'interconnexion métalliques et des couches diélectriques de faibles permittivité qui sont également fragiles mécaniquement. Ces plots de contact forment généralement des vias, ou TSV, réalisés dans les circuits.

Le test des plots de contact d'un tel circuit est généralement réalisé via l'utilisation d'une carte à pointes destinée à être appliquée sur le circuit avec une certaine pression afin d'obtenir un bon contact électrique entre les pointes et les plots de contact.

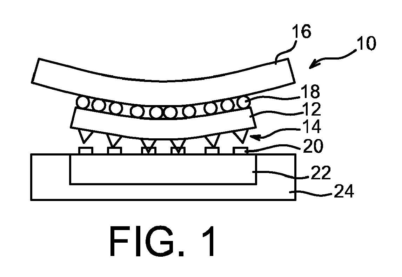

La figure 1 représente schématiquement une telle carte à pointes 10 comportant un premier substrat 12, par exemple en silicium (qui est un matériau ayant un faible coefficient de dilatation thermique, ou CTE). Des pointes 14 comportant un matériau électriquement conducteur, par exemple du métal, sont disposées sur une face avant du premier substrat 12. Le premier substrat 12 est solidarisé, au niveau d'une face arrière, à un deuxième substrat 16 réalisé généralement en un matériau organique ou céramique de CTE plus élevé que celui du matériau du premier substrat 12 et qui permet d'assurer notamment les liaisons électriques entre les pointes 14 et un dispositif électronique de test. Des billes de connexion 18 assurent les liaisons électriques et le maintien mécanique entre la deuxième face du premier substrat 12 et le deuxième substrat 16.

Les pointes 14 sont mises en contact avec des plots de contact 20 d'un dispositif électronique 22 formé dans un substrat 24 lors d'un test du dispositif 22. Idéalement, les pointes 14 et les plots de contact 20 sont disposés selon deux plans parallèles et lorsque la carte à pointes 10 est appliquée sur le dispositif 22, toutes les pointes 14 pénètrent légèrement dans les plots de contact 20, ce qui créé des contacts électriques entre chacune des pointes 14 et l'un des plots de contact 20. En réalité, comme cela est représenté sur la figure 1, la carte à pointes 10 a le plus souvent une forme non plane, généralement incurvée, en raison notamment des traitements thermiques mis en oeuvre lors de la réalisation de la carte à pointes 10 qui créent des contraintes mécaniques et des déformations en raison des différents CTE des matériaux utilisés. En pratique, les extrémités des pointes 14 ne sont donc pas disposées toutes à un même niveau, dans un seul plan. Lorsque les pointes 14 sont appliquées contre les plots de contact 20, certaines de ces pointes 14, notamment celles se trouvant près des bords de la carte à pointes 10, peuvent ne pas être en contact avec les plots de contact 20 disposés en regard de ces pointes 14. De plus, d'autres pointes 14, notamment celles localisées au centre de la carte à pointes 10, peuvent être enfoncées trop profondément dans les plots de contact 20 disposés en regard de ces pointes 14, engendrant une détérioration voire une destruction de ces plots de contact et empêchant ainsi la formation d'un contact électrique correct.

La force avec laquelle les pointes 14 sont appliquées sur les plots de contact 20 du dispositif 22 doit être assez élevée pour obtenir une résistance de contact suffisamment faible entre les pointes 14 et les plots de contact 20. Mais cette force doit également ne pas être trop importante pour que les pointes 14 ne s'enfoncent pas trop dans les plots de contact 20 afin de ne pas les détériorer. Il y a donc un compromis à trouver entre la résistance de contact qui est améliorée en appliquant une force modérée à élevée, et la tenue mécanique des plots de contact qui sont fragiles qui est protégée en appliquant une force modérée ou faible.

La difficulté consiste à observer et définir ce compromis avant l'opération de test. Une carte à pointes doit pouvoir répondre à ce compromis. La carte à pointes de faible pas contient un nombre élevé de pointes de test, généralement plusieurs milliers. Dans certains cas, le compromis est trouvé pour un ensemble de pointes de test mais pas pour la totalité des pointes.

Idéalement, une carte à pointes est réalisée en utilisant un dispositif de référence qui est un circuit fabriqué de la manière la plus fidèle possible au dispositif électronique fonctionnel, ou réel, destiné à être testé, et qui est utilisé pour caractériser la carte à pointes. Le dispositif de référence reproduit toutes les caractéristiques technologiques et géométriques du dispositif électronique fonctionnel tout en permettant d'établir des connexions électriques entre les plots de contact pour faire des mesures électriques à partir de la carte à pointes qui permettent d'estimer la force à appliquer sur les pointes de telle façon que le compromis relatif à la force avec laquelle la carte à pointes est appliquée contre le dispositif électronique soit trouvé pour toutes les pointes.

Faire appel à un dispositif de référence réalisé dans le même procédé technologique que le dispositif électronique fonctionnel peut toutefois être très coûteux. En effet, un faible nombre de dispositifs de référence est généralement requis mais sa fabrication peut impliquer une technologie (la même que celle permettant la fabrication du dispositif électronique fonctionnel) très coûteuse qui ne se justifie que lorsque le volume de production est élevé.

En alternative, il est possible d'utiliser un dispositif électronique fonctionnel pour tester et caractériser la carte à pointes si un dispositif de référence n'a pas lieu d'être fabriqué pour des raisons de coût. Toutefois, les connexions électriques présentes dans le dispositif électronique fonctionnel peuvent ne pas convenir pour caractériser correctement la carte à pointes.

Le document US 8 421491 B2 décrit une carte à pointes dans laquelle les différences de topologies globales de la carte peuvent être compensées en modulant l'épaisseur d'une couche piézoélectrique de la carte à pointes via l'application d'une tension électrique sur cette couche piézoélectrique, modifiant ainsi la position de l'ensemble des pointes. Cette méthode ne tient toutefois pas compte de la topologie locale de la carte, c'est-à-dire au niveau de différentes régions de la carte à pointes considérées individuellement. En outre, une telle carte à pointes ne permet pas de tenir compte de la fragilité du dispositif électronique testé, par exemple lorsque le dispositif électronique testé comporte du silicium aminci comme dans le cas d'une intégration 3D ou de circuits photoniques.

Cette problématique exposée ci-dessus pour les cartes à pointes se retrouve également dans le domaine plus général de l'hybridation permanente (par exemple pour la réalisation de circuits électroniques dits « 3D », c'est-à-dire des circuits électroniques comportant des dispositifs empilés les uns sur les autres, les pointes correspondant dans ce cas à des « micro-inserts ») ou temporaire (correspondant par exemple au cas précédemment exposé dans lequel une carte à pointes est hybridée à un dispositif électronique au cours d'un test) entre des dispositifs ou circuits électroniques, dans lequel des éléments de connexion électrique d'un dispositif de connexion sont destinés à être mis en contact avec des plots de contact d'un dispositif électronique.

**EXPOSÉ DE L'INVENTION**

Un but de la présente invention est de proposer un procédé de caractérisation d'un dispositif de connexion électrique destiné à être hybridé à un dispositif électronique via une mise en contact d'éléments de connexion électrique du dispositif de connexion électrique avec des plots de contact du dispositif électronique, permettant de déterminer s'il existe au moins un bon positionnement du dispositif de connexion électrique vis-à-vis du dispositif électronique permettant d'avoir un bon contact électrique entre tous les éléments de connexion électrique et les plots de contact.

Un but de la présente invention est également de proposer un tel procédé de caractérisation qui puisse être mis en oeuvre à partir d'un dispositif électronique correspondant à un dispositif de référence comportant des plots de contact adaptés à un tel procédé de caractérisation ou bien à un dispositif électronique fonctionnel dont au moins une partie des plots de contact sont reliés électriquement entre eux.

Un but de la présente invention est également de proposer un tel procédé de caractérisation qui tienne compte de la topologie locale du dispositif de connexion électrique et de la fragilité des plots de contact du dispositif électronique.

Pour cela, la présente invention propose un procédé de caractérisation d'un dispositif de connexion électrique destiné à être hybridé à un dispositif électronique et comportant des éléments de connexion électrique chacun destiné à être en contact électrique avec au moins un d'une pluralité de plots de contact du dispositif électronique qui sont reliés électriquement entre eux, comprenant au moins une étape de sélection d'un élément de connexion électrique de référence parmi lesdits éléments de connexion électrique puis, pour le ou chacun des éléments de connexion électrique autres que l'élément de connexion électrique de référence, la mise en oeuvre des étapes suivantes :

- application d'une tension électrique de référence entre l'élément de connexion électrique de référence et ledit élément de connexion électrique ;
- mesure d'un courant électrique circulant à travers l'élément de connexion électrique de référence et ledit élément de connexion électrique, ou d'une résistance électrique entre l'élément de connexion électrique de référence et ledit élément de connexion électrique, en faisant varier la position dudit élément de connexion électrique par rapport à un des plots de contact disposé en regard dudit élément de connexion électrique ;
- détermination de l'existence d'au moins une valeur d'un paramètre lié à la position dudit élément de connexion électrique pour laquelle un contact électrique est correctement établi entre ledit élément de connexion électrique et ledit plot de contact.

Ainsi, ce procédé permet de déterminer s'il existe au moins une bonne position d'un élément de connexion électrique par rapport à un plot de contact se trouvant en regard de l'élément de connexion électrique qui permette d'obtenir un bon contact électrique entre cet élément de connexion électrique et ce plot de contact, et cela pour un ensemble d'éléments de connexion électrique qui sont destinés à être couplés avec des plots de contact qui sont reliés électriquement entre eux. Il est alors possible, en croisant les résultats obtenus pour les différents éléments de connexion électrique, de déterminer s'il existe au moins une position du dispositif de connexion électrique permettant d'avoir un contact électrique correct pour ces éléments de connexion électrique ou pour tous les éléments de connexion électrique du dispositif de connexion électrique, et donc de déterminer si le dispositif de connexion électrique convient pour une hybridation avec le dispositif électronique.

Ce procédé de caractérisation peut être mis en oeuvre à partir d'un dispositif électronique correspondant à un dispositif de référence, ce qui permet dans ce cas de caractériser tous les éléments de connexion électrique du dispositif de connexion électrique, ou bien à un dispositif électronique fonctionnel dont au moins une partie des plots de contact sont reliés électriquement entre eux, ce qui permet dans ce cas de caractériser les éléments de connexion électrique qui sont destinés à être couplés avec ces plots de contact reliés électriquement entre eux.

Enfin, du fait que le contact électrique obtenu est caractérisé individuellement au niveau des différents éléments de connexion électrique, ce procédé de caractérisation tient bien compte de la topologie locale du dispositif de connexion électrique et de la fragilité des plots de contact du dispositif électronique.

Un tel procédé s'applique avantageusement à la caractérisation d'un dispositif de connexion électrique et d'un dispositif électronique dont les éléments de connexion électrique et les plots de contact sont réalisés avec un faible pas (par exemple inférieur ou égal à 100 μm) mais peut également s'appliquer pour de plus grand pas.

Un contact électrique entre un élément de connexion électrique et un plot de contact peut être considéré comme étant correctement établi lorsque la résistance électrique de ce contact est comprise entre environ 1 Ω et 100 kΩ, ou entre environ 1 Ω et 10 kΩ. Lorsque la résistance électrique est inférieure à environ 1 Ω, la résistance de contact est dite très faible ou anormalement faible, et le contact représente quasiment un court-circuit. Un contact électrique entre un élément de connexion électrique et un plot de contact peut être considéré comme quasiment inexistant lorsque la résistance électrique de ce contact est comprise entre environ 100 kΩ et 100 MΩ. Lorsque cette résistance est supérieure à environ 100 MΩ, la résistance est dite très élevée ou anormalement élevée, et le contact représente quasiment un circuit ouvert.

Le dispositif de connexion électrique peut comporter une carte à pointes et les éléments de connexion électrique peuvent comporter des pointes de connexion électrique. Les éléments de connexion électrique peuvent correspondre à des pointes ou des éléments multi-pointes. Chaque pointe peut comporter une extrémité pointue, bombée ou plane. Une forme est dite bombée lorsqu'elle représente une portion d'une sphère, telle qu'un hémisphère, ou qu'elle est de forme arrondie. Contrairement à une forme bombée, une forme est dite plane lorsqu'elle est définie dans un plan.

L'étape de mesure du courant ou de la résistance électrique peut être réalisée depuis une première position dudit élément de connexion électrique dans laquelle ledit élément de connexion électrique n'est pas en contact avec ledit plot de contact et au moins jusqu'à une deuxième position dudit élément de connexion électrique à partir de laquelle le courant ou la résistance électrique mesuré ne varie plus de manière uniforme. Une variation uniforme peut être définie comme étant une variation dont la transformation spectrale (par exemple la transformation de Fourier) ne subit pas une grande dispersion autour de zéro. Par exemple, une variation presque constante ou à peu près linéaire ou à peu près polynomiale peut être considérée comme uniforme.

La deuxième position dudit élément de connexion électrique peut correspondre à une position à partir de laquelle les variations de la valeur du courant ou de la résistance électrique mesuré forment du bruit ou correspondent à des oscillations non cohérentes qui indiquent le début d'une détérioration du plot de contact avec lequel l'élément de connexion électrique est mis en contact (formation d'un circuit ouvert ou d'un court-circuit au niveau de ce plot de contact). Entre les première et deuxième positions, le courant ou la résistance électrique peut varier, dans une partie de cet intervalle de positions, de manière uniforme en formant un plateau.

L'étape de mesure du courant ou de la résistance électrique peut être réalisée jusqu'à une troisième position dudit élément de connexion électrique formant un circuit ouvert ou un court-circuit au niveau dudit plot de contact. De manière générale, l'étape de mesure du courant ou de la résistance électrique peut être mise en oeuvre jusqu'à une troisième position dans laquelle une résistance électrique très élevée (par exemple supérieure à environ 100 MΩ) ou très faible (par exemple inférieure à environ 1 Ω) entre ledit élément de connexion électrique et ledit plot de contact est obtenue.

La variation de la position dudit élément de connexion électrique par rapport au dit plot de contact peut être réalisée en faisant varier une pression avec laquelle le dispositif de connexion électrique est appliqué contre le dispositif électronique, cette pression correspondant au paramètre lié à la position dudit élément de connexion électrique.

En variante, chaque élément de connexion électrique du dispositif de connexion électrique peut comporter des moyens aptes à modifier sa position par rapport à un plot de contact du dispositif électronique disposé en regard de l'élément de connexion électrique indépendamment de la position des autres éléments de connexion électrique et en fonction de la valeur d'une tension électrique de configuration appliquée sur les moyens, et la variation de la position dudit élément de connexion électrique par rapport au dit plot de contact peut être réalisée en faisant varier la tension électrique de configuration appliquée sur les moyens dudit élément de connexion électrique, cette tension électrique de configuration pouvant correspondre au paramètre lié à la position dudit élément de connexion électrique.

Dans ce cas, chaque élément de connexion électrique peut comporter au moins :

- un support dont au moins une première extrémité est ancrée à un substrat du dispositif de connexion électrique telle qu'une partie du support soit suspendue au-dessus d'une face avant du dispositif de connexion électrique, le support comportant au moins une portion de matériau piézoélectrique disposée entre deux électrodes et apte à déplacer ladite partie du support de manière bidirectionnelle sensiblement perpendiculairement à la face avant en fonction de la valeur de la tension électrique de configuration appliquée sur les électrodes ;

- un élément électriquement conducteur disposé sur ladite partie du support.

Dans le cas d'un dispositif de connexion électrique correspondant à une carte à pointes, les éléments électriquement conducteurs peuvent correspondre aux pointes de connexion électrique de la carte.

La détermination de l'existence d'au moins une valeur d'un paramètre lié à la position dudit élément de connexion électrique et pour laquelle un contact électrique est correctement établi entre ledit élément de connexion électrique et ledit plot de contact peut comporter au moins la mise en oeuvre des étapes suivantes :

- détermination d'une valeur Fmin du paramètre lié à la position dudit élément de connexion électrique pour laquelle le contact électrique entre ledit élément de connexion électrique et ledit plot de contact est correctement établi et à partir de laquelle le courant ou la résistance électrique mesuré varie de manière uniforme ;
- détermination d'une valeur Fmax du paramètre lié à la position dudit élément de connexion électrique pour laquelle le contact électrique entre ledit élément de connexion électrique et ledit plot de contact est correctement établi et à partir de laquelle le courant ou la résistance électrique mesuré ne varie plus de manière uniforme ;
- détermination d'un intervalle des valeurs [X % de Fmin; Y % de Fmax], X et Y étant des coefficients de valeurs comprises entre environ 75 et 125.

Dans ce cas, le procédé peut comporter en outre une étape de détermination de l'existence d'une intersection des intervalles de valeurs [X % de Fmin ; Y % de Fmax] pour tout ou partie des éléments de connexion électrique autres que l'élément de connexion électrique de référence.

Ainsi, il est possible de déterminer une gamme de valeurs du paramètre lié à la position dudit élément de connexion électrique, par exemple de la pression avec laquelle le dispositif de connexion électrique est appliqué contre le dispositif électrique ou de la tension de configuration appliquée sur les moyens de commande de la position des éléments de connexion électrique, pour lesquelles un contact électrique est correctement établi pour l'ensemble des éléments de connexion électrique testés, et donc sans dégradation ou destruction des plots de contacts disposés en regard de ces éléments de connexion électrique. Pour une telle gamme de valeurs, le dispositif de connexion électrique est donc parfaitement fonctionnel pour une hybridation avec le dispositif électronique.

La valeur de Fmax peut correspondre à la valeur du paramètre lié à la position dudit élément de connexion électrique (par exemple Pmax lorsque ce paramètre correspond à la pression avec laquelle le dispositif de connexion électrique est appliqué contre le dispositif électrique, ou Vmax lorsque ce paramètre correspond à la tension de configuration appliquée sur les moyens de commande de la position des éléments de connexion électrique) pour laquelle l'élément de connexion électrique se trouve dans la deuxième position (celle à partir de laquelle le courant ou la résistance électrique mesuré ne varie plus de manière uniforme).

La détermination d'au moins une valeur d'un paramètre lié à la position dudit élément de connexion électrique et pour laquelle un contact électrique est correctement établi entre ledit élément de connexion électrique et ledit plot de contact peut comporter en outre une étape de détermination d'une valeur Fdest du paramètre lié à la position dudit élément de connexion électrique à partir de laquelle une variation du courant ou de la résistance électrique mesuré augmente en raison d'une détérioration dudit plot de contact, et le procédé peut comporter en outre, lorsqu'il est déterminé qu'une intersection des intervalles des valeurs [X % de Fmin ; Y % de Fmax] n'existe pas, une étape de détermination de l'existence d'une intersection des intervalles des valeurs [X % de Fmin ; Z % de Fdest] précédemment déterminées, avec Z compris entre environ 75 et 95.

L'existence d'une intersection des intervalles des valeurs [X % de Fmin ; Z % de Fdest] peut donc permettre d'identifier une gamme de valeurs du paramètre lié à la position dudit élément de connexion électrique pour laquelle le dispositif de connexion électrique est partiellement fonctionnel pour une hybridation avec le dispositif électronique.

Ladite pluralité de plots de contact du dispositif électronique peut correspondre à l'ensemble des plots de contact du dispositif électronique. Une telle configuration correspond par exemple à un dispositif électronique correspondant à un dispositif de référence, ou bien à un dispositif électronique fonctionnel permettant un accès à tous ses plots de contact comme par exemple un dispositif électronique de routage tel qu'un interposeur.

En variante, ladite pluralité de plots de contact du dispositif électronique peut correspondre à une partie de l'ensemble des plots de contact du dispositif électronique, et lorsque l'ensemble des plots de contact du dispositif électronique comporte d'autres plots de contact du dispositif électronique qui sont reliés électriquement entre eux et distincts de ladite pluralité de plots de contacts, les étapes du procédé peuvent être répétées pour d'autres éléments de connexion électrique du dispositif de connexion électrique qui sont destinés à être en contact avec lesdits autres plots de contact. Les différents groupes de plots de contact reliés électriquement entre eux peuvent correspondre à des plots de contact d'alimentation électrique du dispositif électronique et/ou des plots de contact de masse du dispositif électronique.

Dans ce cas, le procédé peut comporter en outre, lorsqu'il est déterminé qu'une intersection des intervalles des valeurs [X % de Fmin ; Y % de Fmax] existe, une étape de calcul par interpolation d'un intervalle des valeurs [X % de Fmin ; Y % de Fmax] pour chacun des éléments de connexion électrique du dispositif de connexion électrique pour lesquels un intervalle des valeurs [X % de Fmin ; Y % de Fmax] n'a pas été précédemment déterminé et, lorsqu'il est déterminé qu'une intersection des intervalles des valeurs [X % de Fmin ; Z % de Fdest] existe, une étape de calcul par interpolation d'intervalles des valeurs [X % de Fmin ; Z % de Fdest] pour chacun des éléments de connexion électrique du dispositif de connexion électrique pour lesquels un intervalle des valeurs [X % de Fmin ; Z % de Fdest] n'a pas été précédemment déterminé.

Dans les paragraphes ci-dessus, les valeurs Fmin, Fmax et Fdest peuvent être appelées Pmin, Pmax et Pdest lorsque le paramètre considéré est la pression avec laquelle le dispositif de connexion électrique est appliqué contre le dispositif électronique, ou être appelées Vmin, Vmax et Vdest lorsque le paramètre considéré est la tension électrique de configuration appliquée sur les moyens commandant la position des éléments de connexion électrique par rapport aux plots de contact.

Lorsque le paramètre considéré est la tension électrique de configuration, la détermination d'au moins une valeur d'un paramètre lié à la position dudit élément de connexion électrique et pour laquelle un contact électrique est correctement établi entre ledit élément de connexion électrique et ledit plot de contact peut comporter au moins la mise en oeuvre des étapes suivantes :

- détermination d'une valeur Vmin de la tension électrique de configuration pour laquelle ledit élément de connexion électrique n'est pas en contact avec ledit plot de contact ;
- détermination d'une valeur Vmax de la tension électrique de configuration pour laquelle un contact électrique est correctement établi entre ledit élément de connexion électrique et ledit plot de contact sans détériorer ledit plot de contact.

Les valeurs Vmin et Vmax peuvent être mémorisées afin que chaque élément de connexion électrique puisse être positionné dans la position souhaitée (absence ou non de contact avec le plot se trouvant en regard) lors de l'hybridation.

La valeur Vmax de la tension électrique de configuration peut positionner ledit élément de connexion électrique dans une position intermédiaire entre une première position pour laquelle un contact électrique est correctement établi entre ledit élément de connexion électrique et ledit plot de contact et à partir de laquelle le courant ou la résistance électrique mesuré varie de manière uniforme et une deuxième position pour laquelle un contact électrique est correctement établi entre ledit élément de connexion électrique et ledit plot de contact et à partir de laquelle le courant ou la résistance électrique mesuré ne varie plus de manière uniforme.

**BRÈVE DESCRIPTION DES DESSINS**

La présente invention sera mieux comprise à la lecture de la description d'exemples de réalisation donnés à titre purement indicatif et nullement limitatif en faisant référence aux dessins annexés sur lesquels :

- la figure 1 représente schématiquement une carte à pointes hybridée à un dispositif électronique ;
- la figure 2 représente un organigramme d'un procédé de caractérisation d'un dispositif de connexion électrique, objet de la présente invention, selon un premier mode de réalisation ;
- les figures 3 et 4 représentent des exemples de mesures d'un courant électrique réalisées lors d'un procédé de caractérisation d'un dispositif de connexion électrique, objet de la présente invention ;
- la figure 5 représente un organigramme d'un procédé de caractérisation d'un dispositif de connexion électrique, objet de la présente invention, selon un deuxième mode de réalisation ;
- la figure 6 représente un exemple de réalisation d'un élément de connexion électrique à position configurable ;
- les figures 7 et 8 représentent des exemples de mesures d'un courant électrique réalisées lors d'un procédé de caractérisation d'un dispositif de connexion électrique, objet de la présente invention ;
- la figure 9 représente un organigramme d'un procédé de caractérisation d'un dispositif de connexion électrique, objet de la présente invention, selon un troisième mode de réalisation.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

## EXPOSÉ DÉTAILLÉ DE MODES DE RÉALISATION PARTICULIERS

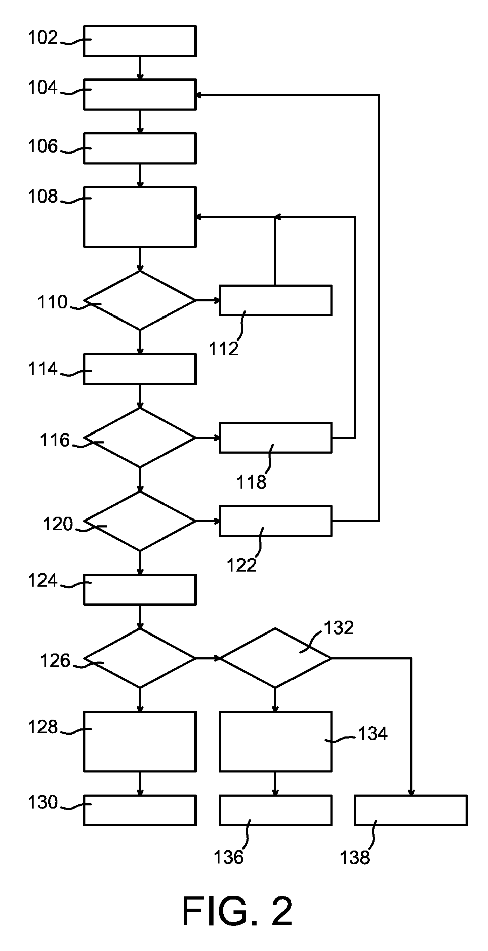

La figure 2 représente sous la forme d'un organigramme un procédé de caractérisation d'un dispositif de connexion électrique, ici une carte à pointes, selon un premier mode de réalisation, permettant de déterminer si la carte à pointes peut être utilisée ou non pour réaliser le test d'un dispositif électronique donné. Ce premier mode de réalisation est par exemple mis en oeuvre lorsqu'une partie seulement des pointes, c'est-à-dire les éléments de connexion électrique, de la carte à pointes sont destinées à être testées, par exemple lorsqu'aucun dispositif de référence n'est disponible et lorsque le dispositif électronique fonctionnel utilisé pour ce procédé comporte des plots de contact dont une partie seulement sont, ou peuvent être, reliés électriquement les uns aux autres pour servir au test des pointes se trouvant en regard de ces plots, tels que des plots faisant partie d'un ou plusieurs réseaux d'alimentation électrique du dispositif électronique et/ou des plots faisant partie d'un ou plusieurs réseaux de masse du dispositif électronique.

Ce procédé est mis en oeuvre à partir d'une carte à pointes similaire à la carte à pointes 10 précédemment décrite en liaison avec la figure 1.

En variante, chaque pointe 14 peut correspondre à une unique pointe ou à une multi-pointe, c'est-à-dire un ensemble de plusieurs pointes, par exemple trois pointes. De tels éléments multi-pointes sont bien adaptés pour réaliser des contacts électriques avec des plots de contact de forme bombée et durs, correspondant par exemple à des billes métalliques, car dans ce cas, de tels plots de contact peuvent aisément s'insérer entre les pointes de chacun des éléments multi-pointes. Les éléments multi-pointes sont ainsi bien centrés par rapport aux plots de contact du dispositif testé et évitent de dégrader de tels plots de contact arrondis et durs. Une distance entre les sommets de deux pointes d'un tel élément multi-pointe est par exemple inférieure à environ 15 $\mu$m.

Selon une autre variante, les pointes 14 peuvent correspondre à des portions de matériau électriquement conducteur dont le sommet est de forme bombée ou plane. Une telle portion conductrice comporte par exemple un métal de fluage tel que du SnAg ou du NiAu, dont la dureté est inférieure au métal formant des pointes 14 dont le sommet est pointu, ou bien un métal plus dur tel que du tungstène. De tels éléments sont bien adaptés pour réaliser un contact électrique avec des plots de contact du dispositif testé qui ne sont pas adaptés à un contact par des pointes dont les extrémités sont pointues, comme par exemple des plots en cuivre entourés d'isolant en formant une surface plane par exemple destinée à être reportée sur une puce par collage direct. De tels éléments permettent de conserver l'intégrité des plots de contact. Le facteur de forme, ou ratio d'aspect, de ces portions conductrices peut être supérieur à 1 voire supérieur à 10 ou 30. Un tel facteur de forme élevé est avantageux lorsqu'une grande souplesse mécanique est requise, ou lorsque l'espacement entre la portion conductrice et le plot de contact est variable ou élevé. Le facteur de forme, appelé AR, d'une telle portion conductrice ou d'une pointe est défini par la formule suivante :

$$AR = H \, / \, (4\pi S)^{1/2}$$

avec H correspondant à la hauteur de la pointe ou de la portion conductrice (dimension selon l'axe Z), et S correspondant à la surface de sa projection dans le plan du substrat (parallèle au plan (X,Y)).

Une étape 102 consiste tout d'abord à sélectionner, parmi l'ensemble des pointes 14 de la carte à pointes 10, un ensemble T de pointes destinées à être testées, par exemple celles qui se trouvent en regard de plots de contact correspondant à au moins une partie des plots du dispositif électronique et qui sont reliés électriquement les uns aux autres. Cet ensemble T peut correspondre à un ensemble des pointes se trouvant en regard des plots faisant partie d'un réseau d'alimentation électrique du dispositif électronique ou d'un réseau de masse du dispositif électronique.

Lors d'une étape 104, une pointe de référence A, ou élément de connexion électrique de référence, est sélectionnée parmi les pointes de l'ensemble T. La pointe de référence A est choisie parmi les pointes de l'ensemble T de préférence telle qu'elle corresponde à celle présentant le minimum de résistance électrique avec les lignes électriques qui la connecte aux autres pointes.

Lors d'une étape 106, une pointe de test B est sélectionnée parmi les pointes de l'ensemble T autres que la pointe de référence A.

Une tension électrique de référence Vref est appliquée aux bornes des pointes de test B et de référence A, et une pression P est ensuite appliquée sur la carte à pointes 10 afin de créer en contact des pointes avec le dispositif électronique (étape 108). Un courant I circulant entre la pointe de référence A et la pointe de test B (et qui traverse donc également les deux plots de contact avec lesquels les pointes A et B sont en contact) est ensuite mesuré (étape 108). Cette mesure du courant est réalisée en augmentant progressivement la valeur de la pression P, par exemple jusqu'à aboutir à un circuit ouvert ou un court-circuit au niveau du plot de contact se trouvant contre la pointe de test B.

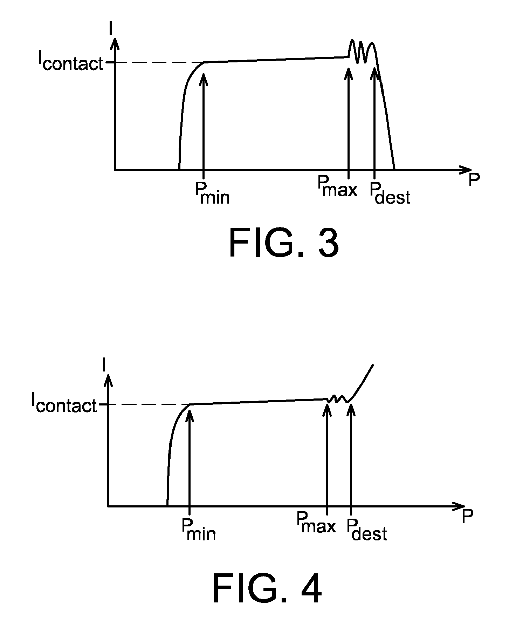

La figure 3 représente un premier exemple de courant I ainsi mesuré en fonction de la valeur de P. Sur cette figure, le courant I passe rapidement d'une valeur nulle (en raison de l'absence de contact d'au moins l'une des pointes A ou B avec le plot de contact correspondant) à une première valeur appelée Icontact au niveau d'une première valeur de P appelée Pmin. Cette première valeur Icontact correspond à la valeur du courant qui circule une fois qu'un contact électrique entre la pointe de test B et le plot de contact se trouvant en regard de la pointe de test B et qu'un contact électrique entre la pointe de référence A et le plot de contact se trouvant en regard de la pointe de référence A sont correctement établis (pouvant correspondre à une brisure d'un oxyde natif présent sur ces plots de contact par les pointes A et B). La valeur de P est incrémentée jusqu'à atteindre une deuxième valeur de P appelée Pmax. Cette valeur de Pmax correspond à la valeur de P au-delà de laquelle la valeur de I n'augmente plus de manière sensiblement constante ou uniforme (entre Pmin et Pmax, la valeur de I augmente de manière uniforme ou constante, ce qui se traduit par la formation d'un plateau sur la courbe I(P) mesurée entre Pmin et Pmax, en raison de la pénétration progressive des pointes dans les plots de contact qui améliore les contacts électriques et réduit donc la résistance électrique entre les pointes et les plots de contact). Au-delà de Pmax, la valeur de I ne varie plus de manière uniforme et les variations du courant correspondent à du bruit (ou encore des oscillations non-cohérentes). La présence de ce bruit peut être par exemple identifiée via une transformée de Fourrier réalisée sur les valeurs I(P). La valeur de P est encore incrémentée jusqu'à atteindre une troisième valeur de P appelée Pdest. Cette valeur de Pdest correspond à la valeur de P au-delà de laquelle la valeur de I chute brutalement jusqu'à devenir nulle, ce qui traduit le début de la formation d'un circuit ouvert au niveau d'au moins un des plots de contact associés aux pointes de référence A et de test B (brisure d'une partie du BEOL (« Back-End Of Line ») du dispositif au niveau de ces plots de contact). La détection de la brisure du BEOL permet d'anticiper ce phénomène pendant une phase élastique des déformations (juste avant une déformation irréversible), de telle sorte que la mesure est arrêtée avant que la brisure irréversible se produise.

Dans le procédé décrit en liaison avec la figure 2, une décision est prise au niveau d'une étape 110 pour savoir si la pression Pdest est atteinte ou non (via la détection de la chute brutale de la valeur de I). Si la pression Pdest n'est pas atteinte, la valeur de P est incrémentée (étape 112). Si la pression Pdest est atteinte, le procédé passe à une étape 114 au cours de laquelle les valeurs de Pmin, Pmax et Pdest sont déterminées (par exemple via des calculs réalisés informatiquement à partir de la courbe I (P)).

Dans l'exemple décrit ci-dessus, à partir de la pression Pdest, la valeur de I chute brutalement en raison de l'apparition d'un circuit ouvert. En variante, il est possible qu'un court-circuit se produise au niveau d'au moins un des plots de contact associés aux pointes de référence A et de test B, à la place de l'apparition d'un circuit ouvert. Un tel court-circuit est également la conséquence d'une brisure du BEOL. La brisure du BEOL peut donc engendrer un circuit ouvert ou un court-circuit selon la configuration du défaut final.

La figure 4 représente un deuxième exemple de courant I mesuré en fonction de la valeur de P dans lequel, au-delà de la valeur de Pdest, la valeur de I ne chute pas brutalement mais au contraire augmente brutalement par rapport à la valeur Icontact en raison de l'apparition du court-circuit.

Dans tous les cas, l'apparition d'un bruit sur la courbe I(P) à partir de Pmax signifie que la valeur Pdest est bientôt atteinte.

En variante de la mesure du courant circulant en fonction de la pression, étant donné que la valeur Vref est constante, il est possible de mesurer la variation de la résistance électrique entre les pointes A et B en fonction de la pression P. Dans ce cas, entre P=0 et P=Pmin, la valeur de la résistance passe brutalement d'une valeur infinie à une valeur Rcontact. Entre Pmin et Pmax, la valeur Rcontact est baisse légèrement en raison de l'amélioration de contact électrique due à la pénétration des pointes dans les plots de contact. Entre Pmax et Pdest, du bruit est observé, comme pour le cas de la mesure du courant. Au-delà de Pdest, la valeur de la résistance augmente ou chute brutalement selon qu'un circuit ouvert ou un court-circuit apparaisse au niveau d'au moins un des plots de contact. La détermination des valeurs Pmin, Pmax et Pdest à l'étape 114 est réalisée à partir des mesures R(P).

Au cours d'une étape 116, il est déterminé si toutes les pointes de l'ensemble T (hormis la pointe de référence A) ont été testées. Si ce n'est pas le cas, une pointe de l'ensemble T qui n'a pas encore été testée est sélectionnée comme étant la nouvelle pointe de test B (étape 118) et les étapes 108 à 116 sont alors répétées avec cette nouvelle pointe de test B.

Lorsque toutes les pointes de l'ensemble T, hormis la pointe de référence A, ont été testées, le procédé passe à l'étape 120 au cours de laquelle il est déterminé s'il reste d'autres pointes à tester, par exemple des pointes se trouvant en regard de plots de contact d'un autre réseau d'alimentation électrique ou d'un autre réseau de masse du dispositif électronique et qui n'ont pas encore été testées. Si c'est le cas, un nouvel ensemble T de pointes à tester est sélectionné (étape 122) et les étapes 104 à 120 sont répétées à partir de ce nouvel ensemble T de pointes.

Lorsque toutes les pointes à tester ont été testées, toutes les valeurs Pmin, Pmax et Pdest déterminées sont par exemple regroupées dans un fichier informatique spécifique. Ces valeurs sont superposées puis comparées les unes par rapport aux autres (étape 124).

Lors d'une étape 126, il est déterminé s'il existe une intersection des intervalles des valeurs [Pmin ; Pmax]

précedemment déterminées (étape 126). Si c'est le cas, cela signifie qu'il existe une ou plusieurs valeurs de la pression P pour lesquelles un bon contact électrique est possible simultanément entre toutes les pointes testées et les plots de contact qui se trouvent en regard de ces pointes, sans destruction de ces plots de contact. Dans ce cas, connaissant la forme géométrique de la carte à pointes 10 (par exemple une forme incurvée sur l'exemple de la carte représentée sur la figure 1), les valeurs des intervalles [Pmin ; Pmax] pour les pointes non testées (par exemple celles se trouvant en regard de plots de contact qui ne sont pas reliés électriquement entre eux) sont calculées par interpolation, puis une intersection I de tous les intervalles [Pmin ; Pmax] (à la fois ceux des pointes testées et ceux des pointes non testées) est déterminée (étape 128), ce qui permet de déterminer une ou plusieurs valeurs de la pression P pour laquelle un bon contact électrique est possible simultanément entre toutes les pointes de la carte 10 et tous les plots de contact du dispositif électronique, sans destruction de ces plots de contact (étape 130). La carte à pointes 10 est considérée alors comme parfaitement fonctionnelle pour cette ou ces valeurs de pression P, et est utilisable pour réaliser des tests sur des dispositifs électroniques similaires au dispositif électronique utilisé lors de ce procédé de test.

S'il n'existe pas d'intersection pour tous les intervalles de valeurs [Pmin ; Pmax] précédemment déterminées pour les pointes testées, il est alors déterminé s'il existe une intersection pour les intervalles de valeurs [Pmin ; Z % de Pdest], avec Z qui est par exemple égal à 90, ou compris entre environ 75 et 95 (étape 132). Si c'est le cas, cela signifie qu'il existe une ou plusieurs valeurs de la pression P pour laquelle un contact électrique est possible entre les pointes testées et les plots de contact qui se trouvent en regard de ces pointes, avec toutefois un risque de destruction ou de dégradation mécaniquement élastique ou irréversible de certains de ces plots de contact. Dans ce cas, connaissant la forme géométrique de la carte à pointes 10, les valeurs des intervalles [Pmin ; Z % de Pdest] pour les pointes non testées sont calculées par interpolation, puis une intersection I de tous les intervalles [Pmin ; Z % de Pdest] est déterminée (étape 134), ce qui permet de déterminer une ou plusieurs valeurs de la pression P pour laquelle un contact électrique est possible entre toutes les pointes de la carte et tous les plots de contact (étape 136). La carte à pointes 10 est considérée alors comme partiellement fonctionnelle pour cette ou ces valeurs de pression P, et est utilisable tout de même pour réaliser des tests sur des dispositifs électroniques similaires au dispositif électronique utilisé lors de ce procédé de test.

S'il n'existe pas d'intersection pour les intervalles de valeurs [Pmin ; Z % de Pdest] précédemment déterminées pour les pointes testées, la carte à pointes 10 est alors considérée comme non fonctionnelle (étape 138) et ne sera pas utilisée pour le test de dispositifs électroniques similaires au dispositif électronique utilisé lors de ce procédé de test.

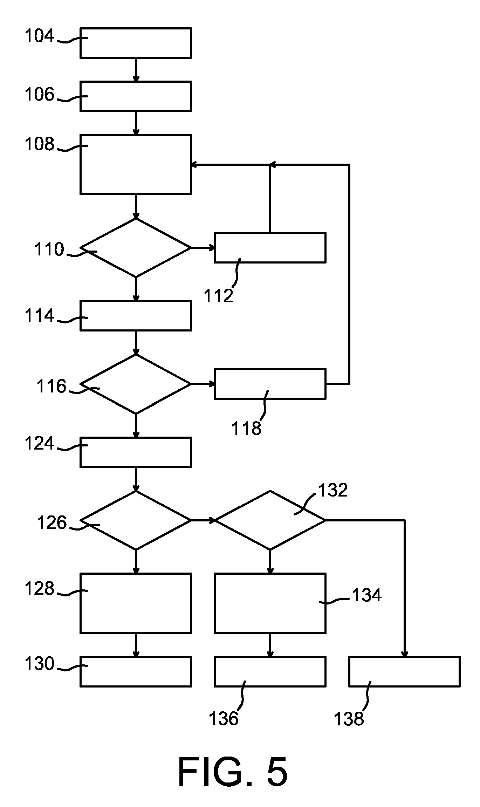

La figure 5 représente sous la forme d'un organigramme un procédé de caractérisation d'un dispositif de connexion électrique, ici une carte à pointes, selon un deuxième mode de réalisation, permettant de déterminer si la carte à pointes peut être utilisée ou non pour réaliser le test d'un dispositif électronique donné. Ce deuxième mode de réalisation est mis en oeuvre lorsque toutes les pointes, c'est-à-dire tous les éléments de connexion électrique, de la carte à pointes sont destinées à être testées, par exemple lorsqu'un dispositif de référence peut être utilisé pour ce test ou lorsque les plots de contact du dispositif électronique fonctionnel utilisé pour ce procédé peuvent tous être reliés électriquement les uns aux autres, par exemple lorsque le dispositif électronique fonctionnel est un dispositif de routage tel qu'un interposeur passif. Dans ce cas, les plots de contact du dispositif électronique peuvent être reliés électriquement entre eux au niveau d'une face arrière du dispositif électronique, par exemple grâce à une couche temporaire conductrice court-circuitant les plots, les pointes étant destinées à venir en contact avec les plots au niveau d'une face avant du dispositif électronique.

Dans ce deuxième mode de réalisation, l'étape 104 au cours de laquelle une pointe de référence A est sélectionnée parmi les pointes de la carte est tout d'abord mise en oeuvre, sans la mise en oeuvre préalable d'une étape de sélection d'un ensemble T de pointes puisque toutes les pointes seront testées.

Une pointe de test B est ensuite sélectionnée, cette pointe de test B étant différente de la pointe de référence A (étape 106).

Les étapes 108 à 118 précédemment décrites en liaison avec le premier mode de réalisation sont ensuite mises en oeuvre. Les valeurs Pmin, Pmax et Pdest sont alors déterminées pour l'ensemble des pointes de la carte à pointes. Ces valeurs sont superposées puis comparées les unes par rapport aux autres (étape 124).

Les étapes 126 à 138 précédemment décrites en liaison avec le premier mode de réalisation sont ensuite mises en oeuvre afin de déterminer si la carte à pointes est parfaitement fonctionnelle, partiellement fonctionnelle ou non fonctionnelle, et ainsi savoir si cette carte peut être utilisée pour le test de ce dispositif électronique.

Dans les deux modes de réalisation précédemment décrits, une pression P appliquée sur la carte à pointes est considérée comme correspondant au paramètre lié à la position des pointes par rapport aux plots de contact. En variante, il est possible de prendre en compte une force appliquée sur la carte à pointes, ou un autre paramètre lié à la position des pointes par rapport aux plots de contact.

Selon une variante de ces deux modes de réalisation, les étapes 132, 134 et 136 peuvent être omises. Dans ce cas, le procédé de test permet uniquement de déterminer si la carte à pointes est parfaitement fonctionnelle ou non fonctionnelle.

Selon une autre variante, pour la mise en oeuvre des étapes 126 et 128, il est possible de prendre en compte un intervalle autre que [Pmin ; Pmax]. Par exemple, si une marge de sécurité supplémentaire est souhaitée pour garantir l'absence de destruction des plots de contact, il est possible de prendre en compte, à la place de cet intervalle, les valeurs de 110% de Pmin et/ou celles de 90% de Pmax, ou bien un intervalle plus restreint encore. Il est possible de considérer par exemple les intervalles [X % de Pmin ; Y % de Pmax], avec X et Y compris entre environ 75 et 120. De plus, pour la mise en oeuvre des étapes 132 et 134, il est possible de prendre en compte un intervalle autre que [Pmin ; Z % de Pdest], par exemple [X % de Pmin ; Z % de Pdest].

Un tel procédé de caractérisation peut également être mis oeuvre pour un dispositif de connexion électrique dont les éléments de connexion électrique comportent des moyens permettant d'ajuster individuellement la position des éléments de connexion électrique par rapport au dispositif électronique.

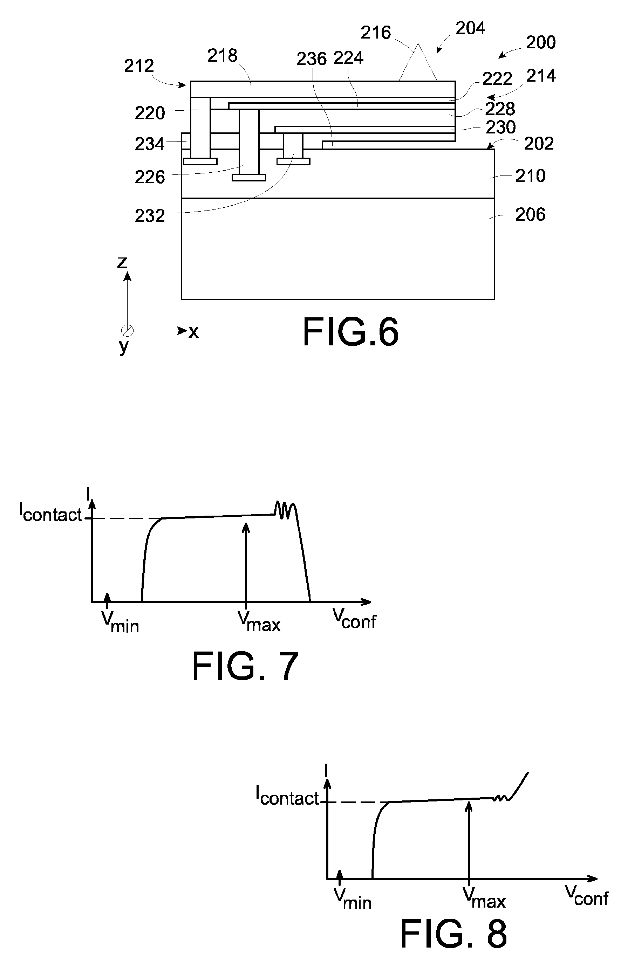

Un exemple de réalisation d'un tel dispositif de connexion électrique 200, qui correspond à une carte à pointes, est représenté sur la figure 6. La carte 200 comprend, sur une face avant 202, des éléments de connexion électrique 204 destinés à être couplés à des plots de contact du dispositif électronique testé. Sur la figure 6, bien que la carte 200 comporte un nombre d'éléments 204 par exemple égal à plusieurs centaines, ou plusieurs milliers ou plusieurs dizaines de milliers, et disposés par exemple en matrice, un seul élément 204 est représenté.

La carte 200 comporte un substrat 206 comprenant par exemple du semi-conducteur tel que du silicium. Une ou plusieurs couches d'interconnexions électriques (BEOL), non visibles sur la figure 6, sont disposées sur le substrat 206, du côté de la face avant 202, et forment, dans plusieurs couches diélectriques 210 comportant au moins un matériau minéral tel que du $SiO_2$, du SiON, du SiN, etc., et déposées sur une face avant du substrat 206, un ou plusieurs niveaux d'interconnexions électriques reliés notamment aux éléments 204.

Chaque élément 204 est ici réalisé sous la forme d'une membrane souple comportant une première extrémité 212 ancrée au substrat 206 et une deuxième extrémité 214 libre, c'est-à-dire non solidarisée au substrat 206, au niveau de laquelle est disposé un élément électriquement conducteur 216, correspondant à une pointe, ou un insert, de test destiné à être en contact ou non avec un plot de contact du dispositif testé selon la position de l'élément 204. L'élément 216 comporte avantageusement du métal tel que du cuivre, du tungstène, de l'aluminium, du nickel ou encore du rhodium, ou bien un semi-conducteur recouvert de métal. L'élément 216 est destiné à être appliqué contre un plot de contact du dispositif testé avec une force permettant une pénétration mécanique de l'élément 216 dans le plot de contact du dispositif testé. Le ou les matériaux de l'élément 216 sont choisis notamment en fonction de la dureté désirée pour former le contact avec le plot de contact du dispositif testé, et donc en fonction notamment de la fragilité de ce plot de contact.

L'élément 216 est disposé sur une portion électriquement conductrice 218 comportant ici une forme allongée et correspondant à un élément de la membrane souple. La portion 218 comporte au moins un matériau électriquement conducteur tel que du silicium dopé ou siliciuré, et/ou du métal (par exemple du cuivre, de l'aluminium, du tungstène ou du nickel, ou l'un de ceux décrits ci-dessus pour l'élément 216) et/ou du graphite. La portion 218 est reliée à l'un des niveaux d'interconnexions électriques par l'intermédiaire d'un premier plot conducteur 220.

Une portion diélectrique 222 est disposée entre la portion 218 et une première électrode 224 comportant par exemple un métal tel que du titane. La première électrode 224 est reliée à l'un des niveaux d'interconnexions électriques par l'intermédiaire d'un deuxième plot conducteur 226. La première électrode 224 est disposée sur une portion de matériau piézoélectrique 228, comportant par exemple du PZT et/ou de l'AIN, elle-même disposée sur une deuxième électrode 230. La deuxième électrode 230 est reliée à l'un des niveaux d'interconnexions électriques par l'intermédiaire d'un troisième plot conducteur 232. La deuxième électrode 230 et la portion 228 reposent sur une portion d'ancrage 234, par exemple en semi-conducteur tel que du silicium ou en un matériau diélectrique (une conduction électrique avec cette portion pouvant dans ce cas être réalisée par un via conducteur supplémentaire si nécessaire), dont une première partie repose sur les couches diélectriques 210 et forme ainsi l'ancrage de la première extrémité 212 de l'élément 204 au substrat 206. Les plots conducteurs 220, 226 et 232 traversent cette première partie de la portion 234. Une deuxième partie de la portion 234 ne repose pas sur les couches diélectriques 210 mais est suspendue au-dessus de la face avant 202 en formant un espace 236 entre l'élément 204 et les couches diélectriques 210.

Lorsqu'une tension de polarisation Vconf est appliquée aux bornes des électrodes 224, 230 vias les plots conducteurs 226 et 232, la portion de matériau piézoélectrique 228 fléchit, sous l'effet de la polarisation électrostatique, soit en direction de la face avant 202, ce qui réduit l'épaisseur de l'espace 236 au niveau de la deuxième extrémité 214 (il peut même y avoir un contact entre la deuxième extrémité 214 et la face avant 202), soit dans une direction opposée augmentant ainsi l'épaisseur de l'espace 236 au niveau de la deuxième extrémité 214. La position de l'élément 216 le long de l'axe Z (axe orienté perpendiculairement à la direction selon laquelle s'étend la membrane formée par l'élément 204, l'axe Z étant également perpendiculaire au plan formé par la face avant 202) est donc fonction de la valeur de la tension de polarisation Vconf appliquée aux bornes des électrodes 224, 230. L'élément 216 peut donc être positionné selon au moins trois positions différentes : une première position basse lorsque la membrane fléchit en direction du substrat 206, une deuxième position intermédiaire lorsqu'aucune tension de polarisation n'est appliquée aux bornes des électrodes 224, 230 (cas représenté sur la figure 6), et une troisième position haute lorsque la membrane fléchit dans la direction opposée à celle vers le substrat 206. Ainsi, lorsque l'élément 216 est destiné à être en contact avec un plot de contact du dispositif testé, cet élément 216 peut être configuré en position haute. Lorsque l'élément 216 est destiné à ne pas être en contact avec un plot de contact se trouvant en regard de l'élément 216, celui-ci peut être soit laissé dans la position intermédiaire, soit configuré dans la position basse afin d'éviter tout risque de contact entre l'élément 216 et le plot de contact.

Les tensions électriques de polarisation Vconf peuvent être appliquées aux bornes des électrodes 224, 230 des éléments 204 soit par le biais d'un dispositif externe à la carte 200 et reliés aux niveaux d'interconnexions électriques de la carte 200, soit par le biais de points mémoires formés dans la carte 200, par exemple dans les couches diélectriques 210, et qui délivrent par exemple des signaux correspondants aux tensions de polarisation Vconf aux bornes des électrodes 224, 230.

Les éléments 216 peuvent être reliés à un système, ou interface, de test (non représenté sur la figure 6) via les portions 218, les plots 220 et les couches d'interconnexions électriques, pour injecter ou tracer un signal (tension ou courant) depuis ou vers les éléments 216.

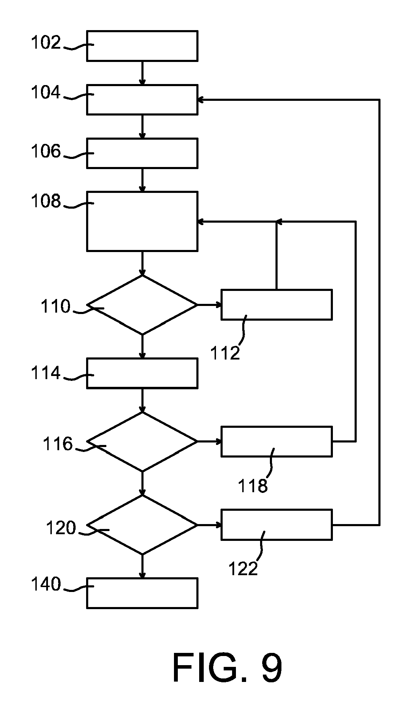

Avec de tels éléments de connexion électrique dont la position est commandable individuellement, le procédé de caractérisation mis en oeuvre peut permettre de déterminer, pour chacun des éléments de connexion électrique, des valeurs Vmin et Vmax de la tension de polarisation Vconf permettant de positionner l'élément de connexion électrique respectivement dans une position ne réalisant pas de contact entre l'élément de connexion électrique et le plot de contact associé et dans une position permettant de réaliser un bon contact électrique entre l'élément de connexion électrique et le plot de contact associé. L'organigramme d'un tel procédé selon un troisième mode de réalisation est représenté sur la figure 9

Comme précédemment décrit, l'étape 104 permettant de sélectionner un élément de connexion électrique de référence A est mise en oeuvre (avec éventuellement la mise en oeuvre préalable de l'étape 102 de sélection de l'ensemble T d'éléments de connexion électrique selon le dispositif électronique utilisé pour le procédé). L'un des éléments de connexion électrique est sélectionné comme l'élément de connexion de test B (étape 106).

Le procédé est ensuite mis en oeuvre en réalisant, à l'étape 108, non pas la mesure de I(P) ou R(P), mais en réalisant la mesure de I(Vconf) ou R(conf). Ainsi, la carte 200 est disposée en regard du dispositif électronique et la valeur du courant circulant entre l'élément de connexion de test B et l'élément de connexion de référence A (ou la résistance électrique entre ces éléments) est mesurée en faisant varier la tension de polarisation Vconf. La valeur de Vconf varie progressivement (incrémentation de la valeur de Vconf à l'étape 112) telle que l'élément de connexion passe d'un état d'absence de contact avec le plot de contact se trouvant en regard de celui-ci à un état de contact entre l'élément de connexion et le plot de contact. Cette variation de la tension de polarisation Vconf continue jusqu'à ce qu'un bruit apparaisse sur la courbe I(Vconf) ou R(Vconf) et que la valeur du courant ou de la résistance chute ou augmente brutalement, traduisant le début de l'apparition d'un circuit ouvert ou d'un court-circuit au niveau du plot de contact (décision prise à l'étape 110).

Des exemples de mesures obtenues sont représentés sur les figures 7 et 8. Pour chaque élément de connexion testé, une valeur Vmin est définie comme étant une valeur de la tension Vconf pour laquelle l'élément de connexion n'est pas encore en contact avec le plot de contact qui lui est associé (courant I nul ou résistance R de valeur infinie). Une valeur Vmax est également définie comme étant une valeur de la tension Vconf se situant entre Vmin et celle pour laquelle le bruit apparaît, par exemple environ au milieu du plateau formé sur la courbe I(Vconf) ou R(Vconf) (sensiblement à égale distance entre la valeur de Vconf pour laquelle I = Icontact et la valeur de Vconf à partir de laquelle du bruit apparaît). Ainsi, la valeur Vmin permet de positionner l'élément de connexion tel qu'il n'y ait pas de contact avec le plot de contact et la valeur Vmax permet de positionner l'élément de connexion tel qu'un bon contact électrique soit obtenu avec le plot de contact. Les valeurs Vmin et Vmax sont déterminées à l'étape 114.

Le processus est réitéré pour tous les éléments de connexion électrique dont la position est configurable qui sont destinés à être testés (étapes 116, 118, 120, 122).

Dans cette configuration, la mesure du courant ou de la résistance peut être stoppée par exemple à partir de l'apparition du bruit sur les courbes I(Vconf) ou R(Vconf).

Un calcul par interpolation pour déterminer les valeurs Vmin et Vmax pour les éléments de connexion électrique non testés est éventuellement mis en oeuvre si tous les éléments de connexion électrique n'ont pas été testés (étape 140).

Les valeurs Vmin et Vmax déterminées peuvent être mémorisées dans un registre qui est fourni avec le dispositif de connexion électrique pour sa reconfiguration lors de l'utilisation du dispositif.

Comme dans les deux premiers modes de réalisation précédemment décrits, il est possible d'appliquer des coefficients de pondération aux valeurs Vmin et Vmax, avec dans ce cas le procédé mis en oeuvre en considérant X % de Vmin et Y % de Vmax.

En variante, des étapes analogues aux étapes 124, 126, 128, 130, 132, 134, 136 et 138 des procédés précédemment décrits en liaison avec les figures 2 et 5 peuvent être mises en oeuvre après l'étape 120 du procédé décrit ci-dessus en liaison avec la figure 9. De telles étapes sont mises en oeuvre en considérant les valeurs Vmin, Vmax et Vdest à la place des valeurs Pmin, Pmax et Pdest.

Dans les modes et exemples de réalisation précédemment décrits, le procédé de caractérisation est mis en oeuvre pour caractériser une carte à pointes destinée à servir au test d'un dispositif électronique fonctionnel. Il est également possible que ces procédés soient mis en oeuvre pour caractériser des dispositifs de connexion électrique servant à la réalisation de circuits électroniques dits « 3D », c'est-à-dire des circuits électroniques comportant des dispositifs empilés les uns sur les autres, les éléments de connexion électrique correspondant dans ce cas à des « micro-inserts », ou plus généralement tout type de dispositif de connexion électrique comportant des éléments de connexion électrique et destiné à être hybridé à un dispositif électronique comportant des plots de contact.

**Revendications**

1. Procédé de caractérisation d'un dispositif de connexion électrique (10, 200) destiné à être hybridé à un dispositif électronique (22) et comportant des éléments de connexion électrique (14, 204) chacun destiné à être en contact électrique avec au moins un d'une pluralité de plots de contact (20) du dispositif électronique (22) qui sont reliés électriquement entre eux, comprenant au moins une étape (104) de sélection d'un élément de connexion électrique de référence parmi lesdits éléments de connexion électrique (14, 204), puis, pour le ou chacun des éléments de connexion électrique autres que l'élément de connexion électrique de référence, la mise en oeuvre des étapes suivantes :

   - application (108) d'une tension électrique de référence entre l'élément de connexion électrique de référence et ledit élément de connexion électrique ;
   - mesure (108) d'un courant électrique circulant à travers l'élément de connexion électrique de référence et ledit élément de connexion électrique, ou d'une résistance électrique entre l'élément de connexion électrique de référence et ledit élément de connexion électrique, en faisant varier la position dudit élément de connexion électrique par rapport à l'un des plots de contact (20) disposé en regard dudit élément de connexion électrique ;
   - détermination (114, 124, 126, 130, 132, 136) de l'existence d'au moins une valeur d'un paramètre lié à la position dudit élément de connexion électrique pour laquelle un contact électrique est correctement établi entre ledit élément de connexion électrique et ledit plot de contact.

2. Procédé selon la revendication 1, dans lequel le dispositif de connexion électrique (10, 200) comporte une carte à pointes et les éléments de connexion électrique (14, 204) comportent des pointes de connexion électrique.

3. Procédé selon l'une des revendications précédentes, dans lequel l'étape de mesure (108) du courant ou de la résistance électrique est réalisée depuis une première position dudit élément de connexion électrique dans laquelle ledit élément de connexion électrique n'est pas en contact avec ledit plot de contact et au moins jusqu'à une deuxième position dudit élément de connexion électrique à partir de laquelle le courant ou la résistance électrique mesuré ne varie plus de manière uniforme.

4. Procédé selon la revendication 3, dans lequel l'étape de mesure (108) du courant ou de la résistance électrique est réalisée jusqu'à une troisième position dudit élément de connexion électrique formant un circuit ouvert ou un court-circuit au niveau dudit plot de contact.

5. Procédé selon l'une des revendications précédentes, dans lequel la pluralité de plots de contact (20) du dispositif électronique (22) correspond à l'ensemble des plots de contact du dispositif électronique (22).

6. Procédé selon l'une des revendications 1 à 4, dans lequel ladite pluralité de plots de contact (20) du dispositif électronique (22) correspond à une partie de l'ensemble des plots de contact du dispositif électronique (22), et lorsque l'ensemble des plots de contact du dispositif électronique (22) comporte d'autres plots de contact du dispositif électronique (22) qui sont reliés électriquement entre eux et distincts de ladite pluralité de plots de contacts (20), les étapes du procédé sont répétées pour d'autres éléments de connexion électrique du dispositif de connexion électrique (10, 200) qui sont destinés à être en contact avec lesdits autres plots de contact.

7. Procédé selon l'une des revendications précédentes, dans lequel la variation de la position dudit élément de connexion électrique par rapport au dit plot de contact est réalisée en faisant varier une pression avec laquelle le dispositif de connexion électrique est appliqué contre le dispositif électronique (22), cette pression correspondant au paramètre lié à la position dudit élément de connexion électrique.

8. Procédé selon l'une des revendications 1 à 6, dans lequel chaque élément de connexion électrique (204) du dispositif de connexion électrique (200) comporte des moyens (224, 228, 230) aptes à modifier sa position par rapport à un plot de contact (20) du dispositif électronique (22) disposé en regard de l'élément de connexion électrique (204) indépendamment de la position des autres éléments de connexion électrique (204) et en fonction de la valeur d'une tension électrique de configuration appliquée sur les moyens (224, 228, 230), et dans lequel la variation de la position dudit élément de connexion électrique (204) par rapport au dit plot de contact (20) est réalisée en faisant varier la tension électrique de configuration appliquée sur les moyens (224, 228, 230) dudit élément de connexion électrique (204), cette tension électrique de configuration correspondant au paramètre lié à la position dudit élément de connexion électrique (204).

9. Procédé selon la revendication 8, dans lequel chaque élément de connexion électrique (204) comporte au moins :

- un support dont au moins une première extrémité (212) est ancrée à un substrat (206) du dispositif de connexion électrique (200) telle qu'une partie du support soit suspendue au-dessus d'une face avant (202) du dispositif de connexion électrique (200), le support comportant au moins une portion de matériau piézoélectrique (228) disposée entre deux électrodes (224, 230) et apte à déplacer ladite partie du support de manière bidirectionnelle sensiblement perpendiculairement à la face avant (202) en fonction de la valeur de la tension électrique de configuration appliquée sur les électrodes (224, 230) ;
- un élément électriquement conducteur (216) disposé sur ladite partie du support.

10. Procédé selon l'une des revendications 7 à 9, dans lequel la détermination (114, 124, 126, 130, 132, 136) de l'existence d'au moins une valeur d'un paramètre lié à la position dudit élément de connexion électrique et pour laquelle un contact électrique est correctement établi entre ledit élément de connexion électrique et ledit plot de contact comporte au moins la mise en oeuvre des étapes suivantes :

- détermination (114) d'une valeur Fmin du paramètre lié à la position dudit élément de connexion électrique (204) pour laquelle le contact électrique entre ledit élément de connexion électrique et ledit plot de contact est correctement établi et à partir de laquelle le courant ou la résistance électrique mesuré varie de manière uniforme ;
- détermination (114) d'une valeur Fmax du paramètre lié à la position dudit élément de connexion électrique (204) pour laquelle le contact électrique entre ledit élément de connexion électrique et ledit plot de contact est correctement établi et à partir de laquelle le courant ou la résistance électrique mesuré ne varie plus de manière uniforme ;
- détermination (124) d'un intervalle des valeurs [X % de Fmin ; Y % de Fmax], X et Y étant des coefficients de valeurs comprises entre environ 75 et 125.

11. Procédé selon la revendication 10, comportant en outre une étape (126, 128) de détermination de l'existence d'une intersection des intervalles de valeurs [X % de Fmin; Y % de Fmax] pour tout ou partie des éléments de connexion électrique autres que l'élément de connexion électrique de référence.

12. Procédé selon la revendication 11, dans lequel la détermination (114, 124, 126, 130, 132, 136) d'au moins une valeur d'un paramètre lié à la position dudit élément de connexion électrique et pour laquelle un contact électrique est correctement établi entre ledit élément de connexion électrique et ledit plot de contact comporte en outre une étape de détermination (114) d'une valeur Fdest du paramètre lié à la position dudit élément de connexion électrique (204) à partir de laquelle une variation du courant ou de la résistance électrique mesuré augmente en raison d'une détérioration dudit plot de contact, et comportant en outre, lorsqu'il est déterminé qu'une intersection des intervalles des valeurs [X % de Fmin ; Y % de Fmax] n'existe pas, une étape de détermination (132, 134) de l'existence d'une intersection des intervalles des valeurs [X % de Fmin ; Z % de Fdest] précédemment déterminées, avec Z compris entre environ 75 et 95.

13. Procédé selon les revendications 6 et 12, comportant en outre, lorsqu'il est déterminé qu'une intersection des intervalles des valeurs [X % de Fmin ; Y % de Fmax] existe, une étape (128) de calcul par interpolation d'un intervalle des valeurs [X % de Fmin ; Y % de Fmax] pour chacun des éléments de connexion électrique du dispositif de connexion électrique (10, 200) pour lesquels un intervalle des valeurs [X % de Fmin ; Y % de Fmax] n'a pas été précédemment déterminé et, lorsqu'il est déterminé qu'une intersection des intervalles des valeurs [X % de Fmin ; Z % de Fdest] existe, une étape (134) de calcul par interpolation d'intervalles des valeurs [X % de Fmin ; Z % de Fdest] pour chacun des éléments de connexion électrique du dispositif de connexion électrique (10, 200) pour lesquels un intervalle des valeurs [X % de Fmin ; Z % de Fdest] n'a pas été précédemment déterminé.

14. Procédé selon l'une des revendications 8 ou 9, dans lequel la détermination (114) d'au moins une valeur d'un paramètre lié à la position dudit élément de connexion électrique (204) et pour laquelle un contact électrique est correctement établi entre ledit élément de connexion électrique (204) et ledit plot de contact (20) comporte au moins la mise en oeuvre des étapes suivantes :

- détermination d'une valeur Vmin de la tension électrique de configuration pour laquelle ledit élément de connexion électrique (204) n'est pas en contact avec ledit plot de contact (20) ;
- détermination d'une valeur Vmax de la tension électrique de configuration pour laquelle un contact électrique est correctement établi entre ledit élément de connexion électrique (204) et ledit plot de contact (20) sans détériorer ledit plot de contact (20).

**15.** Procédé selon la revendication 14, dans lequel la valeur Vmax de la tension électrique de configuration positionne ledit élément de connexion électrique (204) dans une position intermédiaire entre une première position pour laquelle un contact électrique est correctement établi entre ledit élément de connexion électrique (204) et ledit plot de contact (20) et à partir de laquelle le courant ou la résistance électrique mesuré varie de manière uniforme et une deuxième position pour laquelle un contact électrique est correctement établi entre ledit élément de connexion électrique (204) et ledit plot de contact (20) et à partir de laquelle le courant ou la résistance électrique mesuré ne varie plus de manière uniforme.

FIG. 1

FIG. 2

FIG. 3

FIG. 4

FIG. 5

FIG.6

FIG. 7

FIG. 8

FIG. 9

Europäisches
Patentamt

European
Patent Office

Office européen
des brevets

**RAPPORT DE RECHERCHE EUROPEENNE**

Numéro de la demande

EP 15 17 3463

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 2009/068861 A1 (IKEDA HIRONOBU [JP]) 12 mars 2009 (2009-03-12) | 1 | INV. G01R1/067 G01R31/28 |
| A | * alinéa [0041] - alinéa [0147]; figures 1-9 * | 2-15 | |
| A | US 2010/148814 A1 (YALEI SUN [SG] ET AL) 17 juin 2010 (2010-06-17) * abrégé; figure 1 * | 1 | ADD. G01R27/20 |
| A | US 2009/160464 A1 (LANE FREDERICK J [US]) 25 juin 2009 (2009-06-25) * abrégé; figure 2 * | 1 | |
| A | US 2013/321016 A1 (HIRAKAWA HIDEKI [JP] ET AL) 5 décembre 2013 (2013-12-05) * le document en entier * | 1 | |

| DOMAINES TECHNIQUES RECHERCHES (IPC) |
|---|
| G01R |

Le présent rapport a été établi pour toutes les revendications

| Lieu de la recherche | Date d'achèvement de la recherche | Examinateur |
|---|---|---|
| Munich | 29 octobre 2015 | Hijazi, Ali |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
................................................................
& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 15 17 3463

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

29-10-2015

| Document brevet cité au rapport de recherche | Date de publication | Membre(s) de la famille de brevet(s) | Date de publication |
|---|---|---|---|
| US 2009068861 A1 | 12-03-2009 | JP 5077542 B2<br>JP 2009064677 A<br>US 2009068861 A1 | 21-11-2012<br>26-03-2009<br>12-03-2009 |
| US 2010148814 A1 | 17-06-2010 | AUCUN | |
| US 2009160464 A1 | 25-06-2009 | TW 200817687 A<br>US 2008061803 A1<br>US 2009160464 A1<br>WO 2008024727 A1 | 16-04-2008<br>13-03-2008<br>25-06-2009<br>28-02-2008 |
| US 2013321016 A1 | 05-12-2013 | JP 2013246116 A<br>KR 20130133669 A<br>TW 201400820 A<br>US 2013321016 A1 | 09-12-2013<br>09-12-2013<br>01-01-2014<br>05-12-2013 |

EPO FORM P0460

Pour tout renseignement concernant cette annexe : voir Journal Officiel de l'Office européen des brevets, No.12/82

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 8421491 B2